# EUROPEAN PATENT APPLICATION

(11) **EP 4 276 899 A1**
(43) Date of publication of application: **15.11.2023**
(21) Application number: 22173259.7
(22) Date of filing: 13.05.2022
(51) Int. Cl.: H01L 23/485, H01L 23/498, H01L 21/60

(54) **PACKAGE WITH IC SUBSTRATE AND ELECTRONIC COMPONENT CONNECTED WITH DIRECT PHYSICAL CONTACT**

(71) Applicant: AT & S Austria Technologie & Systemtechnik Aktiengesellschaft, 8700 Leoben (AT)
(72) Inventor: Stahr, Johannes, 8605 St. Lorenzen im Mürztal (AT); Leitgeb, Markus, 8793 Trofaiach (AT); Mokkapati, Venkata Raghavendra Subrahmanya Sarma, 8700 Leoben (AT)
(74) Representative: Dilg, Haeusler, Schindelmann Patentanwaltsgesellschaft mbH

(57) **Abstract**

A package (100) which comprises an integrated circuit substrate (102) having an exposed substrate pad (104) and having an exposed substrate dielectric (106), and an electronic component (108) having an integrated circuit (136), having an exposed component pad (110) and having an exposed component dielectric (112), wherein the integrated circuit substrate (102) is connected with the electronic component (108) so that there is a direct physical contact between the substrate pad (104) and the component pad (110) and so that there is a direct physical contact between the substrate dielectric (106) and the component dielectric (112).

## Description

### Field of the Invention

The invention relates to a package, to an integrated circuit substrate, and to a method of manufacturing a package.

### Technological Background

In the context of growing product functionalities of component carriers equipped with one or more components and increasing miniaturization of such components as well as a rising number of components to be connected to the component carriers such as printed circuit boards or integrated circuit substrates, increasingly more powerful array-like components or packages having several components are being employed, which have a plurality of contacts or connections, with smaller and smaller spacing between these contacts. In particular, component carriers shall be mechanically robust and electrically reliable so as to be operable even under harsh conditions.

Conventional approaches of forming and handling component carriers are still challenging in particular what concerns integrated circuit (IC) substrates. In comparison with printed circuit boards, IC substrates are smaller and have a smaller pitch.

### Summary of the Invention

There may be a need to form a compact and reliable IC substrate-type package.

According to an exemplary embodiment of the invention, a package is provided which comprises an integrated circuit substrate having an exposed substrate pad and having an exposed substrate dielectric, and an electronic component having an integrated circuit, having an exposed component pad and having an exposed component dielectric, wherein the integrated circuit substrate is connected with the electronic component so that there is a direct physical contact (in particular a direct physical connection) between the substrate pad and the component pad (at least partially, preferably with full contact) and so that there is a direct physical contact (in particular a direct physical connection) between the substrate dielectric and the component dielectric (at least partially, preferably with full contact).

According to another exemplary embodiment of the invention, an integrated circuit substrate is provided which comprises a stack comprising at least one electrically conductive layer structure having an exposed substrate pad and at least one electrically insulating layer structure having an exposed substrate dielectric, and a recess at a main surface of the stack in which the exposed substrate pad is retracted with respect to the exposed substrate dielectric by a dimension of less than 1 µm.

According to still another exemplary embodiment of the invention, a method of manufacturing a package is provided, wherein the method comprises providing an integrated circuit substrate having an exposed substrate pad and having an exposed substrate dielectric, providing an electronic component having an integrated circuit, having an exposed component pad and having an exposed component dielectric, and connecting the integrated circuit substrate with the electronic component so that there is a direct physical contact between the substrate pad and the component pad and so that there is a direct physical contact between the substrate dielectric and the component dielectric.

In the context of the present application, the term "package" may particularly denote a device having at least one electronic component (such as a semiconductor chip) being surface mounted on a carrier (like an integrated circuit substrate) being mechanically and electrically connected with each other. Such a package may be a constituent of more complex electronic devices.

In the context of the present application, the term "integrated circuit substrate" (IC substrate) may particularly denote a component carrier having a size and a pitch adjusted to the requirements of an integrated circuit component (in particular a semiconductor chip) mounted thereon. An IC substrate may be a, in relation to a PCB, comparably small component carrier onto which one or more integrated circuit components may be mounted and that may act as a connection body between one or more chip(s) and a PCB. For instance, an IC substrate may have substantially the same size as an electronic component to be mounted thereon (for instance in case of a Chip Scale Package (CSP)). In another embodiment, the IC substrate may be larger than the assigned component (for instance in a flip chip ball grid array, FCBGA, configuration). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the IC substrate and can be used to provide electrical, thermal and/or mechanical connections of housed components or unhoused components (such as bare dies), particularly of IC chips, with a printed circuit board or interposer. A dielectric part of an IC substrate may be composed of resin with reinforcing particles (such as reinforcing spheres, in particular glass spheres). A pitch, i.e. a distance between corresponding edges of two adjacent metal structures, of an IC substrate may be not more than 150 µm, in particular not more than 100 µm. In contrast to this, a pitch of a PCB may be at least 200 µm, in particular at least 300 µm.

In the context of the present application, the term "exposed substrate pad" may particularly denote a planar electrically conductive contact element of the integrated circuit substrate being accessible at a main surface of the integrated circuit substrate for electric connection purposes. The main horizontal extension (i.e. perpendicular to the thickness direction of the IC substrate) of the exposed substrate pad may be parallel to the plane of the layers of the IC substrate stack.

In the context of the present application, the term "exposed substrate dielectric" may particularly denote an electrically insulating surface area of the integrated circuit substrate being accessible at a main surface of the integrated circuit substrate for mechanical, but not for electric connection purposes.

In the context of the present application, the term "electronic component having an integrated circuit" (also denoted as IC-type electronic component) may particularly denote a device fulfilling an electronic task and having at least one integrated circuit element (such as a transistor or a diode) monolithically integrated in a semiconductor body (for instance a silicon body or a body being partially of a semiconductor and partially of organic material). Such an electronic component may be an active component such as a semiconductor chip comprising a semiconductor material, in particular as a primary or basic material. Said semiconductor chip may for example be an active semiconductor chip or a passive semiconductor chip (such as a bridge chip). The semiconductor material may for instance be a type IV semiconductor such as silicon or germanium, or may be a type III-V semiconductor material such as gallium arsenide, gallium nitride, indium phosphide. Moreover, semiconductor materials suitable for photonic packages are also possible. In particular, the semiconductor component may be a semiconductor chip such as a bare die or a molded die. A bare die may be a non-encapsulated (in particular non-molded) piece of semiconductor material (such as silicon) having at least one monolithically integrated circuit element (such as a diode or a transistor). For example, such an electronic component may be an HBM (high-bandwidth memory) or a silicon interposer. It is also possible to surface mount a plurality of integrated circuit components on an integrated circuit component mounting side of the integrated circuit substrate.

In the context of the present application, the term "exposed component pad" may particularly denote a planar electrically conductive contact element of the electronic component being accessible at a main surface of the electronic component for electric connection purposes. The main horizontal extension (i.e. perpendicular to the thickness direction of the component) of the exposed component pad may be parallel to the plane of the layers of the IC substrate stack.

In the context of the present application, the term "exposed component dielectric" may particularly denote an electrically insulating surface area of the electronic component being accessible at a main surface of the electronic component for mechanical, but not for electric connection purposes.

In the context of the present application, the term "direct physical contact" may particularly denote a face-to-face contact between two connected entities contacting each other without an additional intermediate material in between. Such a direct physical contact may also establish a direct physical connection between said connected entities. Correspondingly connected entities may not be separated from each other without applying high force and/or thermal energy or without damage.

In the context of the present application, the term "stack" may particularly denote a flat or planar sheet-like body. For instance, the stack may be a layer stack, in particular a laminated layer stack or a laminate. Such a laminate may be formed by connecting a plurality of layer structures by the application of mechanical pressure and/or heat.

In the context of the present application, the term "layer structure" may particularly denote a continuous layer, a patterned layer or a plurality of nonconsecutive islands within a common plane.

In the context of the present application, the term "recess retracted by a dimension of less than 1 µm" may particularly denote a blind hole in a main surface of the integrated circuit substrate having an extremely shallow depth of less than 1 µm, for instance less than 100 nm, preferably less than 20 nm or even less than 10 nm. Such a recess may be created at a main surface of the integrated circuit substrate for exposing an electrically conductive substrate pad defining a bottom area of said recess. To put it shortly, such a recess may provide an accommodation volume for pad material expanding under the influence of energy (for example heat) during establishing a direct connection between integrated circuit substrate and electronic component.

In the context of the present application, the term "main surface" of a body may particularly denote one of two largest opposing surfaces of the body. The main surfaces may be connected by circumferential side walls. The thickness of a body, such as a stack, may be defined by the distance between the two opposing main surfaces.

According to an exemplary embodiment of the invention, a package architecture is provided in which a direct physical connection between an integrated circuit substrate and a surface mounted IC-type electronic component is created for establishing an intimate integrally formed connection in between. For this purpose, not only a direct physical connection between exposed pads of electronic component and integrated circuit substrate but also between exposed dielectric surface regions on facing main surfaces of integrated circuit substrate and electronic component may be established by permanent bonding. By such a direct bonding approach, chip assembly on an IC substrate may be significantly simplified over conventional approaches implementing indirect connection techniques such as soldering or sintering. No intermediate material between IC substrate and electronic component may be necessary according to exemplary embodiments of the invention. This contributes to the compactness of the package in vertical direction, since neither solder material nor an interposer needs to be present between IC substrate and IC-type electronic component. Hence, in addition to a simple assembly process, even shorter z-interconnections (i.e. electrically conductive connections in the vertical direction) may be created.

According to another exemplary embodiment of the invention, an IC substrate being highly appropriately prepared for creating a package having the above-mentioned features is provided. Advantageously, such an IC substrate may comprise one or more exposed substrate pads in one or more extremely shallow recesses on a main surface of the IC substrate. Another part of said main surface (or even the entire remaining part of said main surface) may be defined by an exposed substrate dielectric, i.e. an electrically insulating and preferably planar surface region. Highly advantageously, the one or more recesses may have a bottom area defined by the one or more substrate pads. Said metallic bottom area may delimit an extremely shallow recess with a depth below 1 µm, and preferably in the range of nanometers or tens of nanometers. To put it shortly, such an extremely shallow recess may provide an accommodation volume being capable of accommodating pad material expanding during a thermal connection process for creating a direct physical connection between IC substrate and IC-type electronic component. Thus, the provision of a tiny recess in the connection surface of the IC substrate with a pad-defined bottom may ensure that a connection surface between IC substrate and IC-type electronic component is substantially flat after establishing the mutual connection. In other words, in the absence of a recess of the described type, an interface between IC substrate and IC-type electronic component might be curved or non-planar. A corresponding pad metal protrusion might deteriorate the reliability of the adhesion between both bodies. Advantageously, the provision of one or more recesses at one or more pad positions of an integrated circuit substrate may avoid cracks when pad material expands during a thermal connection process with an IC-type electronic component.

### Detailed Description of Exemplary Embodiments

In the following, further exemplary embodiments of the package, the integrated circuit substrate and the method will be explained.

In an embodiment, a connection area between the substrate dielectric and the component dielectric is coplanar with a further connection area between the substrate pad and the component pad. Thus, both the metallic as well as the dielectric connection areas between IC substrate and IC-type electronic component may lie in the same plane in the readily manufactured package. This may advantageously suppress undesired phenomena such as delamination or warpage.

In an embodiment, the exposed substrate dielectric is formed by a dielectric film, in particular a dielectric oxide film, on a dielectric bulk structure. Thus, a dielectric surface of the IC substrate may be formed by a deposited dielectric thin film or by a surface oxidization treatment of the IC substrate. In particular a dielectric oxide film on the surface of the IC substrate may provide a high degree of smoothness, which may be advantageous for creating a permanent bonding. Such a dielectric film may be a silicon oxide film, but may also be another material (for example it can also be glass, Teflon, etc.).

In an embodiment, the package is free of any material and/or is free of any gap between the integrated circuit substrate and the electronic component. Hence, there may be neither an air gap nor another material belonging neither to the IC substrate nor to the IC-type electronic component in an interface region between IC substrate and IC-type electronic component. This may lead to a high compactness in vertical direction and to simple assembly process.

For example, an external layer of the IC substrate (i.e. the exposed substrate dielectric) comprises organic material, such as an organic compound. An organic compound may be a chemical compound that contains carbon-hydrogen bonds. For example, the organic material may comprise an organic resin material, an epoxy material, etc.

In an embodiment, an external layer of the IC substrate (i.e. the exposed substrate dielectric including exposed substrate pads) connects at least two electronic components provided on its main surface among them. More generally, the package may comprise at least two electronic components connected with direct physical contact on a common integrated circuit substrate, in particular being thereby electrically connected with each other.

In an embodiment, the electronic component can comprise a patch redistribution layer (RDL) on its main surface. More generally, the electronic component may have a main surface used for connecting to the IC substrate and having a planar redistribution layer thereon. In the context of the present application, the term "redistribution layer" may particularly denote a patterned electrically conductive layer which has a portion with a lower pitch as compared to another portion with a higher pitch. Pitch may denote a characteristic distance between adjacent electrically conductive structures, such as wiring elements or terminals. By providing spatially separate regions with different pitch, a redistribution layer may be an electric interface between larger dimensioned electric connection structures (in particular relating to component carrier technology, more particularly printed circuit board technology or integrated circuit substrate technology) and smaller dimensioned electric connection structures (in particular relating to semiconductor chip technology, wherein the surface mounted component may be a semiconductor chip).

In an embodiment, a lateral extension of the substrate pad and/or of the component pad is less than 50 µm, in particular less than 10 µm, for example 5 µm. Advantageously, the described manufacturing architecture is compatible with extremely small pads both on the side of the IC substrate as well as on the side of the IC-type electronic component. Preferably, the pad comprises round three-dimensional shapes, for example cylindrical. Alternatively, non-round three-dimensional shapes, such as cuboids, may be possible. Preferably, a pad may be flat.

In an embodiment, the integrated circuit substrate comprises a core and a build-up on the core, wherein the build-up faces the electronic component. For example, such a core may comprise cured resin (such as epoxy resin), optionally comprising reinforcing particles (such as glass particles, for instance shaped as spheres). In particular, such a core may be made of FR4 material or glass. A fully cured core may provide high mechanical stability. A build-up may be a laminated layer stack, in particular comprising at least two or even at least four stacked layer structures. Such a build-up may form an appropriate electric interface for the electronic component.

In an embodiment, the build-up has a higher integration density than the core. In this context, the term "integration density" may denote a number of electrically conductive elements (in particular trace elements (such as wiring structures), connection elements (such as pads) and/or vertical through connections (such as metallic vias)) per area or volume of the respective portion. Hence, the amount of electrically conductive elements in a higher density portion may be higher than the amount of electrically conductive elements in a lower density portion. Thus, integration density may mean a quantity of electrically conductive elements per area or volume. The integration density in a lower density portion can be less than in a higher density portion. Thus, the build-up may be adjusted to correspond with a characteristic pitch of the surface mounted electronic component. In contrast to this, the core provides mechanical support. Thus, the additional manufacturing effort resulting from the formation of a high-density region next to the electronic component may be limited to the region where absolutely needed. This may reduce the entire manufacturing effort of the package.

As an alternative to the aforementioned embodiment in which the IC substrate comprises a core, another exemplary embodiment may implement an integrated circuit substrate which is coreless, i.e. which does not comprise a core.

In an embodiment, the component dielectric is formed by a passivation layer of the electronic component or by an additional processed dielectric film on a passivation layer of the electronic component. A passivation layer may be provided on a semiconductor chip anyhow and may be used additionally as connection surface to the IC substrate to thereby further reduce the manufacturing effort. In an alternative approach, an additional dielectric film may be applied on the electronic component and in particular on a passivation layer thereof and may be treated specifically for improving adhesion with the dielectric surface of the IC substrate. It is also possible that a planar redistribution layer is formed in such an additional processed dielectric film, i.e. direct in a surface area of the electronic component to be mounted on the IC substrate.

In an embodiment, the substrate pad and the component pad are made of the same material, such as the same metal or the same alloy. For achieving excellent reliability of the connection between IC substrate and IC-type electronic component, both the substrate pad and the component pad may be made of the same metal, for instance copper or gold. Alternatively, both the substrate pad and the component pad may be made of the same alloy. When selecting the material of the substrate pad and the component pad identical, the metallic connection strength between IC substrate and IC-type electronic component may be particularly pronounced. Furthermore, this may avoid any contact resistance and may therefore ensure a low ohmic configuration.

In an embodiment, the integrated circuit substrate is connected with the electronic component with continuous physical contact, preferably with continuous connection force, over an entire main surface of the electronic component. Hence, no unconnected surface regions of the connection main surface of the IC-type electronic component which might be separated without applying a separation force remains in such an embodiment. Therefore, the reliability of the mutual connection between IC substrate and IC-type electronic component may be further improved by taking this measure. Involved connection forces may comprise metal-metal interactions, hydrogen-bond interactions, dipole-dipole interactions, n-n interactions, Van der Waals interactions and/or mixtures thereof.

In an embodiment, at least part of the connection may be formed by diffusion soldering.

In an embodiment, the integrated circuit substrate has a plurality of exposed substrate pads and the electronic component has a plurality of exposed component pads, wherein the integrated circuit substrate is connected with the electronic component so that there is a direct physical contact between the substrate pads and the component pads. More specifically, each of the substrate pads may be connected with direct physical contact with an assigned one of the component pads so that each pair of substrate pad and component pad may be interconnected. Thus, even a plurality of component pads of one electronic component may be connected simultaneously with a plurality of substrate pads of the IC substrate. Hence, even an electronic component (for instance a processor) with a large number of component pads may be assembled in a simple way on a single IC substrate. It is also possible that a plurality of electronic components, each being equipped with an integrated circuit, is connected on a common integrated circuit substrate in the described way.

In an embodiment, the integrated circuit substrate comprises a support structure having at least one hole, and at least two functional inlays placed inside said at least one hole side by side. According to such an embodiment, an IC substrate architecture is provided in which a support structure has embedded functional inlays arranged laterally next to each other and/or spaced with respect to each other. A pitch of not more than 150 µm is a characteristic of an IC substrate in comparison with a PCB having a larger pitch. Advantageously, the support structure (for example a core) may be used in addition to its mechanical support function (and optionally as a redistribution structure) for providing additional functions achieved by embedding functional inlays for providing said functions into one or more holes of the support structure. By taking this measure, a highly flexible and powerful construction set is provided for manufacturing IC substrates with specific application-related or user-defined functional setup. At the same time, such IC substrates may be manufactured with low effort, since simple embedding processes may be sufficient for embedding any desired functional inlay in the IC substrate. Consequently, a multifunctional core with side-by-side located functional inlays may be provided being consequently highly compact in a vertical direction.

In an embodiment, the integrated circuit substrate comprises a central section, and at least two vertically stacked functional volume sections in the central section. According to such an embodiment, the central section (for example a core) may be used in addition to its mechanical support function and optionally as a redistribution structure for providing additional functions achieved by monolithically integrating or embedding functional volume sections for providing said functions above each other in the central section. By taking this measure, a highly flexible construction set is provided for manufacturing IC substrates with specific application-defined or user-defined functional setup. At the same time, such IC substrates may be manufactured with low effort, since simple stacking and/or vertical build-up procedures may be sufficient for implementing any desired functional volume section in the IC substrate. Consequently, a multifunctional core with vertically stacked functional volume sections may be provided being consequently highly compact. In comparison with conventional approaches, a conventional core may be split into different functional volume sections to thereby achieve an augmented density in terms of wiring and functionality.

Still referring to the embodiments mentioned in the two preceding paragraphs, at least one of the following features can be combined with this:
- wherein the support structure has a plurality of holes, and wherein the at least two functional inlays are placed inside said plurality of holes.
- comprising at least three functional inlays inserted in said at least one hole.
- wherein the support structure is a frame structure.
- wherein the support structure is a fully cured core, in particular with through holes.
- wherein at least one of the functional inlays comprises a metallic slug and/or a laminated layer stack, in particular comprising at least two stacked layer structures.
- wherein upper main surfaces of the functional inlays form part of a top main surface of the integrated circuit substrate and/or lower main surfaces of the functional inlays form part of a bottom main surface of the integrated circuit substrate.
- wherein at least one of the functional inlays is configured to provide a power conversion function, in particular a direct current-direct current-converter function.
- wherein at least one of the functional inlays is configured to provide a power distribution function, in particular a redistribution structure function.
- wherein at least one of the functional inlays is configured to provide a power delivery function, in particular provided by a plurality of embedded capacitor components.
- comprising at least one security component embedded in at least one of the functional inlays.
- wherein the pitch at the integrated circuit component mounting side is different in regions of different functional inlays.
- wherein the pitch at the integrated circuit component mounting side is different from a pitch at a mounting base mounting side.
- wherein different ones of the at least two functional inlays which are placed side by side extend over different vertical spatial extensions.
- wherein the central section comprises at least three vertically stacked functional volume sections.
- wherein at least one of the functional volume sections extends vertically over a plurality of stacked layer structures.
- wherein at least one of the functional volume sections comprises a vertical through connection extending vertically only through part of the thickness of the central section.
- wherein at least one of the functional volume sections comprises a horizontally extending wiring structure.
- wherein at least one of the functional volume sections comprises a power converter function, in particular a direct current-direct current-converter function.
- wherein at least one of the functional volume sections comprises a power distribution function, in particular a redistribution structure.
- wherein at least one of the functional volume sections comprises a power delivery function, in particular provided by a plurality of embedded capacitor components.
- comprising at least one security-related component embedded in at least one of the functional volume sections, preferably in an interior of the central section.
- wherein at least one of the functional volume sections comprises at least one heat management structure, in particular for dissipating heat.
- wherein at least one of the functional volume sections comprises at least one electrooptical structure.
- wherein the central section comprises or consists of a mechanically stable material, for example fully cured dielectric material, glass, ceramic or a semiconductor.
- wherein different functional volume sections provide different, in particular cooperating, functions.

In an embodiment, the recess is retracted by a dimension in a range from 1 nm to 20 nm, in particular from 2 nm to 8 nm. Such extremely tiny recesses have turned out to be appropriate for small pads, in particular of copper, as used for an IC substrate. With such dimensions, material expanding during a thermal connection process can be accommodated in the respective recess without substantially protruding beyond the recess. This ensures planarity of the connected surfaces and consequently a reliable connection without the risk of delamination.

In an embodiment, an exposed surface area of the substrate dielectric on said main surface of said stack (in particular next to the recess) has a roughness Ra of less than 10 nm, in particular less than 1 nm. To put it shortly, the surface of the exposed substrate dielectric may be preferably extremely smooth for ensuring a high connection and bond strength with the IC-type electronic component. The mechanical integrity of the package, which may provide an IC substrate-component connection without sinter or solder in between, may thus be significantly improved.

In an embodiment, the exposed substrate dielectric on said main surface of said stack (in particular next to the recess) has a coplanarity of less than 500 nm. In this context, the term "coplanarity" may denote a tolerance value indicating a deviation from a condition according to which the exposed substrate dielectric lies completely within a plane. With a coplanarity below 500 nm, a flatness level may be achieved which reliably ensures an integral connection between IC-type electronic component and IC substrate.

In an embodiment, the method comprises providing the substrate pad in a recess retracted with respect to the substrate dielectric, providing the component pad in a further recess retracted with respect to the component dielectric, and connecting the integrated circuit substrate with the electronic component so that material of the substrate pad and/or material of the component pad is/are heated to expand so as to fill the recesses. During said expansion process, the substrate pad and the component pad may be interconnected. In order to comply with pad material expansion phenomena during a thermal connection process both on the side of the IC substrate as well as on the side of the component, cooperating recesses may be formed on both sides of the pad-pad-connection to be formed. When the recess depth and the thermal expansion of the pad material are selected in a matching way so as to substantially completely fill the recess with expanded pad material during the connection process, formation of a pad-pad connection and a planar connection surface can be synergistically combined and a reliable electric connection in between can the ensured. Preferably, the depth of each of the substrate pad and the component pad may be less than 1 µm, preferably less than 100 nm, in particular in a range from 1 nm to 20 nm and most preferably in a range from 2 nm to 8 nm.

In particular, the material configuration and the heating process may be adjusted so that the pad material expands during heating in a way that the substrate pad material and the component pad material contact each other by the heat-triggered expansion process. In order to achieve this, the depth of the recesses may be adapted accordingly, as described in the preceding paragraph.

In an embodiment, the method comprises connecting the integrated circuit substrate with the electronic component by applying pressure and/or heat. Both heat and pressure may promote formation of a reliable electric connection in particular between the opposing pads. However, also formation of a dielectric-dielectric connection may be stimulated by heat and/or pressure. Preferably, both heat and pressure may be applied to achieve best results.

In an embodiment, the method comprises surface activating the substrate dielectric and/or the component dielectric before the connecting. For example, said surface activation may be a plasma activation of the respective connection surface. This may improve the mechanical integrity of the package at the connection surface between component and substrate.

In an embodiment, the method comprises connecting the integrated circuit substrate with the electronic component by permanent bonding. Preferably, said permanent bonding may be accomplished by hybrid bonding, diffusion bonding and/or thermocompression bonding. However, other permanent bonding processes may be executed as well.

Hybrid bonding may combine a dielectric bond (between the exposed substrate dielectric and the exposed component dielectric) with a metal bond (between the exposed substrate pad and the exposed component pad) to form an interconnection. Hybrid bonding may be executed at room temperature, followed by an annealing process at elevated temperature (for instance in a temperature range from 150°C to 300°C). In particular, hybrid bonding may be initiated at room temperature, between the dielectrics of the component and the IC substrate, further executed by an annealing process at elevated temperature.

Diffusion bonding may denote a solid-state welding technique for joining similar and dissimilar metals. Diffusion bonding may operate on the principle of solid-state diffusion, wherein the atoms of two solid, metallic surfaces intersperse themselves over time. This may be accomplished at an elevated temperature, for example in a temperature range from 50% to 75% of the absolute melting temperature of the materials.

Thermocompression bonding may denote a bonding technique in which two metals are brought into atomic contact applying force and heat simultaneously. The diffusion process may involve atomic contact between the surfaces due to atomic motion. The atoms migrate from one crystal lattice to the other one leading to an atomic interaction sticking the interfaces together.

In an embodiment, the package comprises a mounting base, in particular a printed circuit board (PCB), on which the integrated circuit substrate is mounted. Such a mounting base may connect the IC substrate and its surface mounted component(s) mechanically and electrically with an electronic periphery, such as the IC substrate mounted on the same mounting base.

In an embodiment, a stack of the integrated circuit substrate comprises at least one electrically insulating layer structure and at least one electrically conductive layer structure. For example, the respective stack may be a laminate of the mentioned electrically insulating layer structure(s) and electrically conductive layer structure(s), in particular formed by applying mechanical pressure and/or thermal energy. The mentioned stack may provide a plate-shaped base capable of providing a mounting surface for one or more components and being nevertheless very thin and compact.

In an embodiment, the IC substrate may be shaped as a plate. This contributes to the compact design, wherein the IC substrate nevertheless provides a proper basis for mounting components thereon. Furthermore, in particular a bare die as example for an electronic component, can be conveniently embedded, thanks to its small thickness, into a thin plate-type IC substrate.

The IC substrate may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide, polybenzoxazole, BCB (Benzocyclobutene), or PBO (Poly(p-phenylen-2,6-benzobisoxazol).

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the IC substrate as electrically insulating structures.

In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the respective stack. The component and/or the at least one further component can be selected from a group consisting of an electrically nonconductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in or surface mounted on the IC substrate. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate or an interposer, for example in a board-in-board configuration. The component may be surface mounted on the IC substrate and/or may be embedded in an interior thereof. Moreover, also other components, in particular those which generate and emit electromagnetic radiation and/or are sensitive with regard to electromagnetic radiation propagating from an environment, may be used as component.

In an embodiment, the IC substrate is a laminate. In such an embodiment, the IC substrate is a compound of multiple layer structures which are stacked and connected together by applying a pressing force and/or heat.

After processing interior layer structures of the IC substrate, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or IC substrate.

In particular, an electrically insulating solder resist may be applied to one or both opposing main surfaces of the layer stack or IC substrate in terms of surface treatment. For instance, it is possible to form such a solder resist on an entire main surface and to subsequently pattern the layer of solder resist so as to expose one or more electrically conductive surface portions which shall be used for electrically coupling the IC substrate to an electronic periphery. The surface portions of the IC substrate remaining covered with solder resist may be efficiently protected against oxidation or corrosion, in particular surface portions containing copper.

It is also possible to apply a surface finish selectively to exposed electrically conductive surface portions of the IC substrate in terms of surface treatment. Such a surface finish may be an electrically conductive cover material on exposed electrically conductive layer structures (such as pads, conductive tracks, etc., in particular comprising or consisting of copper) on a surface of a IC substrate. If such exposed electrically conductive layer structures are left unprotected, then the exposed electrically conductive IC substrate material (in particular copper) might oxidize, making the IC substrate less reliable. A surface finish may then be formed for instance as an interface between a surface mounted component and the IC substrate. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Eletroless Palladium Autocatalytic Gold).

The aspects defined above and further aspects of the invention are apparent from the examples of embodiment to be described hereinafter and are explained with reference to these examples of embodiment.
Figure 1 illustrates a cross-sectional view of a package according to an exemplary embodiment of the invention.
Figure 2 illustrates a cross-sectional view of an IC substrate before executing a connection process with an electronic component according to an exemplary embodiment of the invention.
Figure 3 illustrates a connection region of a package according to an exemplary embodiment of the invention.
Figure 4 illustrates a cross-sectional view of constituents of a package according to an exemplary embodiment of the invention.
Figure 5 and Figure 6 illustrate cross-sectional views of constituents of a package according to an exemplary embodiment of the invention during hybrid bonding without external compression.
Figure 7 and Figure 8 illustrate cross-sectional views of constituents of a package according to an exemplary embodiment of the invention during hybrid bonding with external compression.
Figure 9 illustrates a cross-sectional view of a package according to still another exemplary embodiment of the invention.
Figure 10 illustrates a cross-sectional view of a package according to yet another exemplary embodiment of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment of the invention, a package is provided which is composed of an integrated circuit (IC) substrate and an electronic component with IC mounted on the IC substrate. Upon connecting the integrated circuit substrate with the electronic component, a direct physical contact is formed between a substrate pad and a component pad and simultaneously between a substrate dielectric and a component dielectric. For instance, this may be accomplished by a hybrid bonding process. Advantageously, such a manufacturing architecture may allow to connect IC substrate and IC-type electronic component without material in between (in particular without solder and without interposer in between) and therefore with short z-interconnection. This may lead to a compact design and high signal integrity due to short vertical signal paths. Moreover, a high thermal reliability due to low ohmic losses may be achieved. Preferably, a chip surface may fully, i.e. without interruption, touch a substrate surface after connection (for example, a passivation layer of the IC-type component may be in direct contact with an oxide layer on an exterior surface of the IC substrate, and bond pads of the IC substrate may contact directly metal contacts of the chip).

Correspondingly, an exemplary embodiment of the invention provides an integrated circuit substrate with terminals for fine pitch direct chip attachment. A fan-out layer may be added for improving the connection capability on a single layer. More generally, exemplary embodiments may enable fine pitch component assembly on an integrated circuit substrate. Interposers may be eliminated. Reduced losses may be achieved due to less interconnections and shorter signal paths. Furthermore, a supply chain may be simplified. Apart from this, improved impedance control may be achieved by using oxide bonding (in particular with no thickness tolerance of bonding material).

Advantageously, a plurality of packages according to exemplary embodiments of the invention may be formed simultaneously in a batch process. For instance, such a batch process may involve processing of an array of packages simultaneously, or even processing packages on quarter panel or even entire panel level at the same time. Hence, individual packages may be separated from such an array, quarter panel or panel at the end of the manufacturing process. Advantageously, this may allow to manufacture packages with high throughput and on an industrial scale.

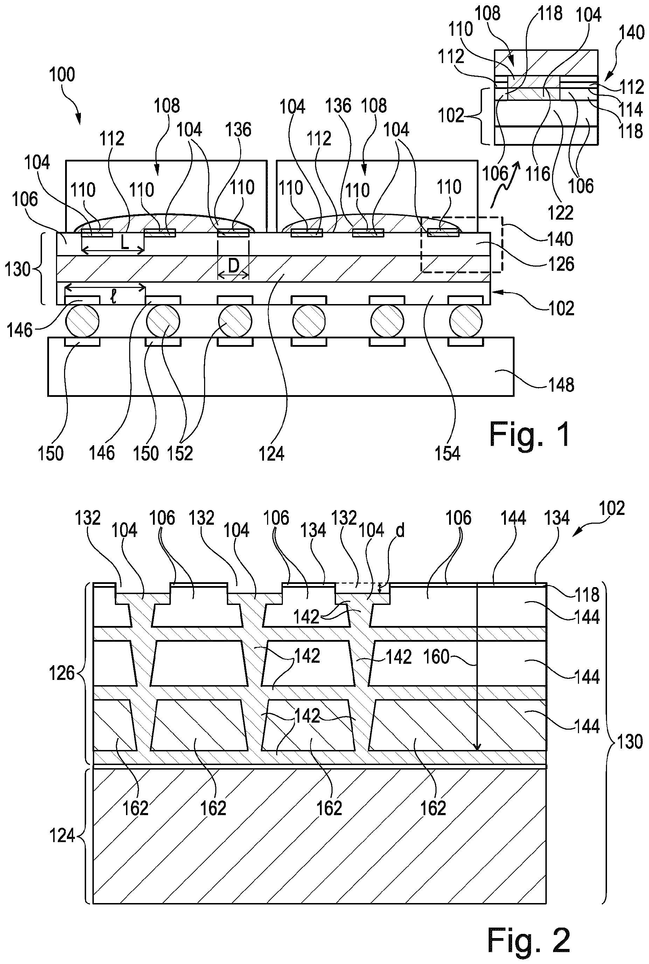

**Figure 1** illustrates a cross-sectional view of a package 100 according to an exemplary embodiment of the invention.

The illustrated package 100 comprises an integrated circuit substrate 102 and comprises two electronic components 108 mounted with full-surface direct physical contact on the integrated circuit substrate 102. Alternatively, a number of electronic components 108 being surface mounted on the integrated circuit substrate 102 may be larger or smaller than two.

On a bottom side of the package 100, a mounting base 148 is provided on which the IC substrate 102 is mounted. For example, the mounting base 148 may be a printed circuit board (PCB) or an interposer. Although not shown in Figure 1, further components (such as further IC substrates, further (in particular molded) semiconductor chips, etc.) may be assembled on the mounting base 148.

For example, the integrated circuit substrate 102 may comprise or consist of a laminated layer stack 130 comprising a plurality of electrically conductive layer structures 142 and of electrically insulating layer structures 144 (see for example Figure 2). The electrically conductive layer structures 142 may comprise patterned copper layers which may form horizontal pads and/or a horizontal wiring structure. Additionally or alternatively, the electrically conductive layer structures 142 may comprise vertical through connections such as copper pillars and/or copper filled laser vias. Moreover, the stack 130 of the integrated circuit substrate 102 may comprise one or more electrically insulating layer structures (such as prepreg or resin sheets). Also surface finish (like ENIG or ENEPIG), a solder resist, etc. may be applied.

The integrated circuit components 108 are here configured as bare dies (i.e. non-encapsulated semiconductor chips) and are surface mounted on a top main surface of the IC substrate 102. The IC components 108 may be configured to semiconductor chips, for instance active semiconductor chips. Examples of the IC components 108 are processors, memories, sensors, logic chips, microelectromechanical systems (MEMS), etc. Each IC component 108 may comprise an integrated circuit 136 with at least one monolithically integrated circuit element, such as a transistor or a diode, in an active region. The IC component 108 can also be a stacked IC.

A detail 140 in Figure 1 shows particularities of the connection surface between the integrated circuit substrate 102 and one of the electronic components 108. As shown in detail 140, the package 100 is free of any material and is free of any gap between the integrated circuit substrate 102 and the electronic component 108 which are connected with each other over a continuous connection area. Thus, the integrated circuit substrate 102 may be connected with the electronic components 108 with continuous physical contact over an entire main surface of the electronic components 108.

Still referring to Figure 1 and in particular to detail 140, the integrated circuit substrate 102 comprises in its upper portion a plurality of exposed substrate pads 104 being surrounded by an exposed substrate dielectric 106. For instance, each of the substrate pads 104 is made of copper material. The exposed substrate dielectric 106 may for instance be organic dielectric material, such as epoxy resin. In the connected state according to Figure 1, exterior planar surface portions of the exposed substrate dielectric 106 and of the exposed substrate pads 104 may be coplanar and at the same vertical level. The avoidance of protrusions and depressions in the substantially flat connection surface between integrated circuit substrate 102 and electronic components 108 may ensure a reliable electric connection as well as an avoidance of cracks.

Still referring to detail 140, the illustrated electronic component 108 has exposed component pads 110 and has an exposed component dielectric 112. For instance, each of the component pads 110 is made of copper material. Advantageously, the material of the substrate pads 104 and of the component pads 110 may be the same which may promote a firm pad-pad connection and thus a good reliability of package 100. The exposed component dielectric 112 may for instance be a passivation layer made of a polymer dielectric material.

In the connected state according to Figure 1, exterior planar surface portions of the exposed component dielectric 112 and of the exposed component pads 110 may be coplanar, i.e. at the same vertical level. Furthermore, exterior planar surface portions of the exposed component pads 110 and of the exposed substrate pads 104 may be coplanar and at the same vertical level as dielectrics 106, 112. Hence, a connection area 114 between the substrate dielectric 106 and the component dielectric 112 is coplanar with a further connection area 116 between the substrate pad 104 and the component pad 110.

As shown in detail 140 as well, the integrated circuit substrate 102 is connected with the illustrated electronic component 108 so that there is a direct physical contact between the substrate pads 104 and the component pads 110. Furthermore, the connection is executed so that there is a direct physical contact between the substrate dielectric 106 and the component dielectric 112. Advantageously, no additional material (such as solder) or element (for instance an interposer) is arranged between the integrated circuit substrate 102 and the electronic components 108. This keeps the vertical dimension of package 100 small so that a compact design may be achieved. Furthermore, this direct connection keeps the electric connection paths short, thereby ensuring high signal integrity and low losses as well as a strong suppression of excessive package heating. Consequently, package 100 may be provided with high thermal, mechanical and electrical reliability.

In the illustrated embodiment, the exposed substrate dielectric 106 can be formed by a thin dielectric film 118, which can be preferably a dielectric oxide film formed by oxidizing a dielectric surface portion of the integrated circuit substrate 102. The thin dielectric firm 118 may be arranged on a thick dielectric bulk structure 122 of the integrated circuit substrate 102. By forming the exposed substrate dielectric 106 with a very smooth thin dielectric firm 118, excellent adhesion properties between integrated circuit substrate 102 and the respective IC-type electronic component 108 may be achieved.

For example, a lateral extension, D, of each of the substrate pad 104 and the component pad 110 may be less than 10 µm. The described manufacturing architecture allows to connect an integrated circuit substrate 102 and electronic components 108 with very small pad dimensions.

As shown as well, a pitch, I, between adjacent bottom-sided pads 146 of the integrated circuit substrate 102 may be larger than a pitch, L, between adjacent top-sided exposed substrate pads 104 of the IC substrate 102. To put it shortly, the pitch, I, of for example the 250 µm matches with the requirements of PCB technology, whereas the pitch, L, of for example the 100 µm matches with the requirements of semiconductor technology. More generally, pitch, L, at the integrated circuit component mounting side of the integrated circuit substrate 102 may be not more than 150 µm, in particular not more than 100 µm. More generally, pitch, I, at a side of the integrated circuit substrate 102 facing mounting base 148 may be more than 200 µm, in particular more than 300 µm. As shown, the bottom-sided pads 146 are electrically coupled with mounting base pads 150 of mounting base 148 by bottom-sided electric connections structures 152 (such as solder balls). In contrast to this, the top-sided substrate pads 104 are directly electrically coupled with the component pads 110 of the IC components 108, i.e. without top-sided electric connections structures (i.e. without solder balls or the like).

What concerns the interior construction of the integrated circuit substrate 102, it may comprise a central core 124, a top-sided build-up 126 on an upper main surface of the core 124, and a bottom-sided build-up 154 on a lower main surface of the core 124. While the top-sided build-up 126 faces the electronic components 108, the bottom-sided build-up 154 faces the mounting base 148. Although not shown in detail in Figure 1, any of the build-ups 126, 154 may comprise stacked laminated layer structures 142, 144.

Preferably, the build-up 126 has a higher integration density than the core 124 and than the build-up 154. Hence, a locally higher integration density may be formed next to the surface mounted IC components 108 having a higher integration density as well. However, a lower integration density may be sufficient next to the mounting base 148 with its lower integration density. This may allow to manufacture the integrated circuit substrate 102 with low effort and to provide one or more regions of higher integration density only where needed. For instance, any of the optional build-ups 126, 154 may contribute to a mechanical strengthening and/or the formation of a redistribution layer in the framework of the package 100.

For example, typical structural dimensions at an interface between the integrated circuit substrate 102 and a respective one of the electronic components 108 may be in the range from 1 µm to 40 µm. In contrast to this, typical structural dimensions at an interface between the integrated circuit substrate 102 and the mounting base 148 may be larger than 200 µm, in particular larger than 300 µm.

**Figure 2** illustrates a cross-sectional view of an IC substrate 102 according to an exemplary embodiment of the invention. The illustrated integrated circuit substrate 102 can be used advantageously as a constituent of package 100 according to Figure 1 but is shown in Figure 2 in a condition prior to connection with electronic components 108.

The integrated circuit substrate 102, shown as a semifinished product in Figure 2, comprises stack 130 composed of the above described electrically conductive layer structures 142, 144, having exposed substrate pads 104, and having an exposed substrate dielectric 106. As shown in Figure 2 as well, recesses 132 are formed as indentations or blind holes at a main surface of the stack 130 in which the exposed substrate pads 104 are retracted with respect to the exposed substrate dielectric 106 by a dimension, d, of preferably not more than 20 nm, most preferred by a dimension, d, in a range from 2 nm to 8 nm. As shown as well in Figure 2, sidewalls of each recess 132 are defined by the exposed substrate dielectric 106, whereas a bottom of each recess 132 is defined by a corresponding exposed substrate pad 104 (preferably made of copper).

This design has advantages: When the illustrated integrated circuit substrate 102 is connected with an electronic component 108 according to Figure 1 by the application of heat (for instance in terms of hybrid bonding), the material of the exposed substrate pad 104 tends to expand thermally. In order to prevent the risk of crack formation during bonding due to thermally expanded copper material protruding beyond the exterior main surface of the exposed substrate dielectric 106, the volume of the recesses 132 can be matched with the additional expansion volume of the substrate pads 104 during the connection process.

Preferably, the integrated circuit substrate 102 offers a coplanarity of less than 500 nm. This means that the dielectric upper main surface of the integrated circuit substrate 102, where the one or more electronic components 108 are to be mounted by permanent bonding, may have a height variation over its entire lateral extension of not more than 500 nm. This provides an appropriate base for the direct face-to-face mounting of the one or more electronic components 108 with matching pad positions. Although the exact value of the coplanarity may depend on design parameters such as pitch, a coplanarity of less than 500 nm is an appropriate choice for many applications. As a rule of thumb, an implemented alignment accuracy may be divided by a factor of 10 to the pitch. As an example, if the pitch is 10 µm, the alignment accuracy may be 1 µm. To put it shortly, a high degree of coplanarity simplifies alignment.

Moreover, terminals with a roughness Ra of less than 1 nm may be advantageous. Preferably, an exposed surface area 134 of the substrate dielectric 106 next to the recess 132 has a roughness Ra of less than 1 nm. This may ensure proper adhesion between integrated circuit substrate 102 and directly connected electronic component(s) 108.

As exposed substrate dielectric 106, an oxidation layer is a highly appropriate choice. A thermal oxide may provide a high surface quality, uniformity and roughness with small defects. Thus, a thermal oxide is highly appropriate for fine pitch interconnections (for instance by diffusion soldering or hybrid bonding).

Moreover, issues concerning a CTE (coefficient of thermal expansion) mismatch between one or more mounted electronic components 108 and integrated circuit substrate 102 may be solved for enabling a reliable interconnection by implementing a stiffness gradient 160 from top to bottom layer and/or by introducing a stress breaking layer 162 in an interior of the stack 130. More specifically, the electrically insulating layer structures 144 of the stack 130 may be made of different dielectric materials to thereby create a stiffness gradient 160 from the main surface (i.e. the surface having the recesses 132) with higher stiffness to an interior of the stack 130 with lower stiffness. Additionally or alternatively, the stack 130 may comprise a dielectric stress breaking layer 162 with locally reduced Young modulus value in an interior of the stack 130. Descriptively speaking, the higher the value of the Young modulus, the stiffer is the corresponding dielectric material. For instance, a high Young modulus material may have a value of the Young modulus above 10 MPa, in particular above 15 MPa. In contrast to this, a low Young modulus material may have a value of the Young modulus below 5 MPa, in particular in a range from 0.5 MPa to 0.7 MPa (in particular for Ajinomoto Build-up Film (ABF) material). Descriptively speaking, the stiffness gradient 160 and/or the dielectric stress breaking layer 162 may function as a bumper. Undesired artefacts connected with excessive CTE mismatch, such as warpage and delamination, may hence be efficiently suppressed.

More generally, the electrically insulating layer structures 144 of the stack 130 may have a stiffness gradient 160 from the main surface with higher stiffness to an interior with lower stiffness. Additionally or alternatively, stack 130 may comprise a dielectric stress breaking layer 162 with locally reduced Young modulus value in an interior of the stack 130. Any of these features may be applied to any embodiment of the invention.

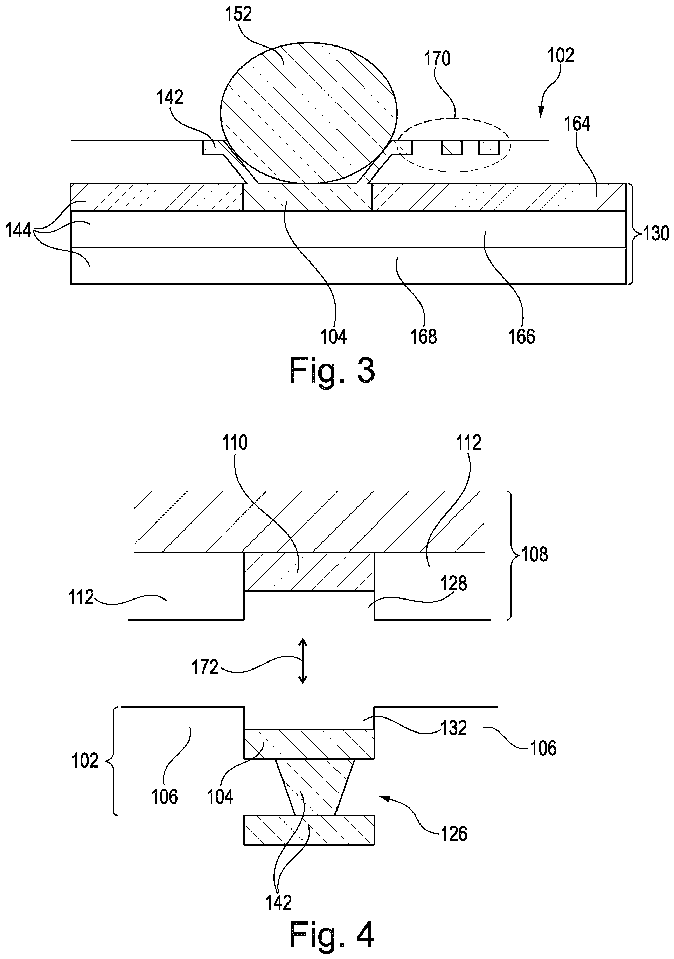

**Figure 3** illustrates a connection region of a package 100 according to an exemplary embodiment of the invention.

Specifically, Figure 3 shows an example of a construction of a portion of an integrated circuit substrate 102 according to an exemplary embodiment. Figure 3 shows an electric connection structure 152, embodied as solder ball, connected on an exposed substrate pad 104. Reference sign 164 shows a fan-out layer which may be created based on a Nanoimprint Lithography (NIL) dielectric for forming a high density routing layer (see reference sign 170). The NIL fan-out layer may be provided with a bottom-sided silicon oxide coating for oxide bonding and/or may be treated by plasma activation. Still referring to the NIL fan-out layer, a layer stack glass-silicon-glass may be provided. Process modification of organosilane may be executed to achieve a high Young modulus of for example 80 GPa. A top layer for oxide bonding may be provided. Directly beneath the fan-out layer, an electrically insulating layer structure 144 with very high Young modulus (for example 70 GPa) is shown with reference sign 166 (for instance a dielectric having a very high filler content, like a mold compound). Below the latter mentioned layer, a further electrically insulating layer structure 144 with high Young modulus (for example 50 GPa) is shown. Optionally, a metallized layer may be sputtered on the backside of the NIL or on the top side of the IC substrate for impedance control. This may be advantageous in particular for high frequency applications.

**Figure 4** illustrates a cross-sectional view of constituents of a package 100 according to an exemplary embodiment of the invention prior to connection. More specifically, Figure 4 shows an arrangement of an integrated circuit substrate 102 and an electronic component 108 in a condition at a beginning of a method of manufacturing a package 100 by directly contacting and thereby connecting the integrated circuit substrate 102 with the electronic component 108.

At the beginning of the connection process, the integrated circuit substrate 102 is provided with an exposed substrate pad 104 and with an exposed substrate dielectric 106. More specifically, the substrate pad 104 is positioned in a recess 132 retracted (i.e. displaced downwardly) with respect to the substrate dielectric 106 prior to connection.

Furthermore, the electronic component 108 (having an integrated circuit 136, not shown in Figure 4) is provided with an exposed component pad 110 and with an exposed component dielectric 112. More precisely, the component pad 110 is positioned in a further recess 128 retracted (i.e. displaced upwardly) with respect to the component dielectric 112 prior to connection.

As shown, the integrated circuit substrate 102 and the electronic component 108 are arranged with the pads 104, 110 in a face-to-face configuration. Furthermore, exposed substrate dielectric 106 and exposed component dielectric 112 are also arranged in a mutual face-to-face configuration. Before directly connecting integrated circuit substrate 102 and electronic component 108, it may be advantageous to treat the substrate dielectric 106 and the component dielectric 112 by surface activation, for instance by plasma activation, for improving the mutual adhesion properties. Thereafter, the integrated circuit substrate 102 is connected with the electronic component 108 (see reference sign 172) by a permanent bonding process so that there is a direct physical contact between the substrate pad 104 and the component pad 110 and so that there is a direct physical contact between the substrate dielectric 106 and the component dielectric 112 (i.e. to achieve a result as shown in Figure 1).

More precisely, the integrated circuit substrate 102 may be connected with the electronic component 108 by applying pressure and heat so that a material of the substrate pad 104 and a material of the component pad 110 are heated and thereby expand so as to fill the recesses 128, 132. Due to such a thermal treatment, metallic (preferably copper) material of pads 104, 110 expands and thereby fills the recesses 128, 132, so that materials of the pads 104, 110 are mutually connected and fill substantially the entire recesses 128, 132.

For instance, the process of connecting the integrated circuit substrate 102 with the electronic component 108 may be carried out by hybrid bonding.

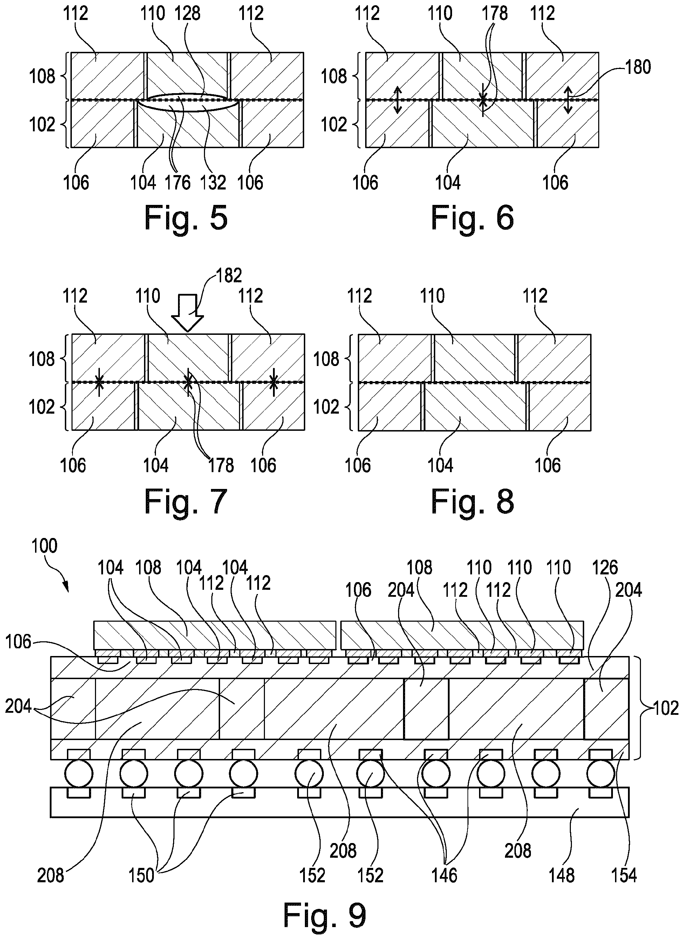

In the following, referring to Figure 5 to Figure 8, different permanent bonding processes for connecting integrated circuit substrate 102 with electronic components 108 will be explained. For example, the dielectric structures corresponding to reference signs 106, 112 may be silicon dioxide, whereas the metallic structures corresponding to reference signs 104, 110 may be copper.

Figure 5 and Figure 6 illustrate cross-sectional views of constituents of a package 100 according to an exemplary embodiment of the invention during hybrid bonding without external compression.

Referring to **Figure 5****,** bonding at room temperature is illustrated. Such a process may lead to dishing, see reference sign 176. Bonding at room temperature between two different dielectric surfaces is illustrated in Figure 5. Furthermore, Figure 5 also illustrates dishing of copper. Preferably, the horizontal extension of pads 104, 110 may be the same. Additionally or alternatively, the horizontal extension of substrate pads 104 may be different (bigger or smaller) compared to the horizontal extension of component pads 110.

Referring to **Figure 6****,** post bonding annealing for copper-copper bonding by self-compression is illustrated. Copper expansion is illustrated with reference sign 178, whereas tensile stress is shown with reference sign 180.

Figure 7 and Figure 8 illustrate cross-sectional views of constituents of a package 100 according to an exemplary embodiment of the invention during hybrid bonding with external compression.

Referring to **Figure 7****,** external compression is indicated with reference sign 182. Bonding is accomplished with thermo-compression at elevated temperature.

Referring to **Figure 8****,** post-bonding annealing for bonding enhancement is illustrated.

**Figure 9** illustrates a cross-sectional view of a package 100 according to still another exemplary embodiment of the invention.

The illustrated package 100 comprises a central integrated circuit substrate 102, also denoted as IC substrate. Furthermore, the package 100 comprises integrated circuit components 108 which are here configured as bare dies (i.e. non-encapsulated semiconductor chips) and which are directly surface mounted on a top main surface of the IC substrate 102, as explained referring to Figure 1.

On a bottom side of the package 100, a mounting base 148 is provided on which the IC substrate 102 is mounted.

Construction and connection of the mounting base 148, the integrated circuit substrate 102 and the at least one integrated circuit component 108 may be as described in any of the above figures, wherein the interior construction of the IC substrate 102 according to Figure 9 can be as follows:

As shown in Figure 9, the integrated circuit substrate 102 comprises a support structure 204 having a plurality of through holes. The support structure 204 serves as a mechanically stable frame structure for mechanically supporting the surface mounted integrated circuit components 108 and for accommodating functional inlays 208. For example, the support structure 204 may be a fully cured core made of FR4 material, optionally with embedded electrically conductive structures therein. Such embedded electrically conductive structures may be, for example, copper filled drill holes, patterned copper layers, etc. Holes for accommodating functional inlays 208 may be formed in the support structure 204 for example by mechanically cutting, by laser processing, by etching or by routing.

In the embodiment of Figure 9, three pre-fabricated functional inlays 208 are placed inside said holes side by side, i.e. sideways or laterally with respect to each other. Each functional inlay 208 may provide a dedicated function, and functions provided by different functional inlays 208 may be different. It is also possible that only two inlays 208 or at least four inlays 208 are provided. In the shown embodiment, one functional inlay 208 per hole is provided. Alternatively, two or more functional inlays 208 may be inserted per hole. It is also possible that a larger or smaller number of holes is provided. It is also possible that blind holes or recesses or cavities are provided additionally or alternatively to through holes. Figure 9 does not show the detailed construction of the functional inlays 208. However, examples for functional inlays 208 which may be pre-fabricated and may then be inserted into the frame-type support structure 108 are given below.

Preferably, the functional inlays 208 may be configured so that the surface mounted integrated circuit components 108 functionally cooperate with the functional inlays 208. For instance, the functional inlays 208 may provide additional functionality in terms of power conversion, power distribution, power delivery, etc.

Again referring to Figure 9, instead of providing a monolithic substrate, the shown embodiment uses sublets or sub-segments in form of the functional inlays 208 which are inserted into the main body of the integrated circuit substrate 102 and each providing a different functionality. Preferably, the functional inlays 208 comprise organic laminate material rather than being a semiconductor chip only. However, a functional inlay 208 may nevertheless comprise one or more embedded components (such as semiconductor chips) in addition to organic laminate material.

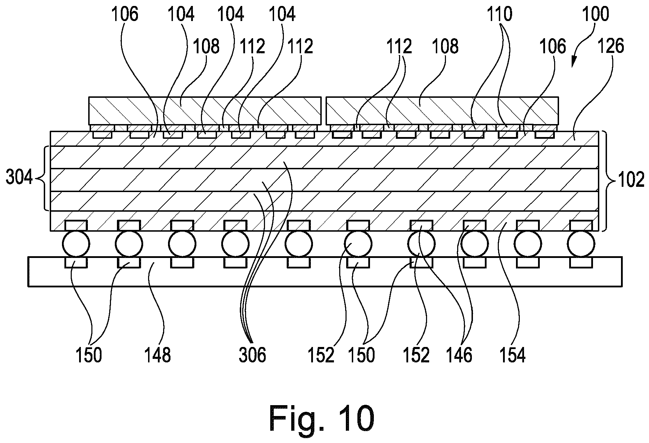

**Figure 10** illustrates a cross-sectional view of a package 100 according to yet another exemplary embodiment of the invention.

Construction and connection of the mounting base 148, the integrated circuit substrate 102 and the at least one integrated circuit component 108 may be as described in any of the above figures, wherein the interior construction of the IC substrate 102 according to Figure 10 can be as follows:
The integrated circuit substrate 102 comprises a central section 304, which may also be denoted as support structure and which can be embodied as a core comprising fully cured dielectric material.

As shown, the central section 304 is composed of three vertically stacked functional volume sections 306. However, the number of vertically stacked functional volume sections 306 may also be two or at least four. In the embodiment of Figure 10, each of the stacked functional volume sections 306 extends over the entire width of the central section 304. As a result, each of the functional volume sections 306 provides mechanical support as well as a dedicated technical function in view of the specific configuration of the respective functional volume section 306. Hence, the shown configuration uses the available volume of the multifunctional central section 304 highly efficiently.

Possible functions which may be implemented in the functional volume sections 306 will be mentioned below.

One, some or all of the functional volume sections 306 may be laminated layer stacks configured in accordance with their dedicated functions, and optionally having one or more embedded components (such as semiconductor chips, or passive devices such as capacitors, inductors or resistors). One, some or all of the functional volume sections 306 may extend vertically over a plurality of stacked layer structures, for instance at least two or at least four. Different functional volume sections 306 may provide different, in particular cooperating, functions.

Instead of providing a monolithic substrate, the shown embodiment provides different sub-cores with specific functions. Some of the functions can be integrated into an arrangement of prepreg sheets and core(s) or into multiple cores. To put it shortly, it may be possible to monolithically form the functional volume sections 306 with the central section 304.

Referring to Figure 9 and Figure 10, possible functions which may be implemented in any of the functional inlays 208 or in any of the functional volume sections 306 may be in particular the following:
- signal routing (in particular for high-speed applications)
- power delivery (in particular by multilayer structures, embedded passive components, etc.)
- thermal functionality (for instance by heat-removing copper slugs)
- an electro-optical transducing function
- formation of an organic or silicon bridge (for instance for fine line structures)
- antenna or other high-frequency functions
- an anti-tamper function (for example embedded memory with crypto-engine)

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. A package (100), wherein the package (100) comprises:
an integrated circuit substrate (102) having an exposed substrate pad (104) and having an exposed substrate dielectric (106);
an electronic component (108) having an integrated circuit (136), having an exposed component pad (110) and having an exposed component dielectric (112);
wherein the integrated circuit substrate (102) is connected with the electronic component (108) so that there is a direct physical contact between the substrate pad (104) and the component pad (110) and so that there is a direct physical contact between the substrate dielectric (106) and the component dielectric (112).

2. The package (100) according to claim 1, wherein a connection area (114) between the substrate dielectric (106) and the component dielectric (112) is coplanar with a further connection area (116) between the substrate pad (104) and the component pad (110).

3. The package (100) according to any of claims 1 to 2, wherein the package (100) is free of any material and/or is free of any gap between the integrated circuit substrate (102) and the electronic component (108).

4. The package (100) according to any of claims 1 to 3, wherein a lateral extension (D) of the substrate pad (104) and/or of the component pad (110) is less than 50 µm, in particular less than 10 µm.

5. The package (100) according to any of claims 1 to 4, wherein the integrated circuit substrate (102) comprises a core (124) and a build-up (126) on the core (124), wherein the build-up (126) faces the electronic component (108).

6. The package (100) according to claim 5, wherein the build-up (126) has a higher integration density than the core (124).

7. The package (100) according to any of claims 1 to 6, wherein the component dielectric (112) is formed by a passivation layer of the electronic component (108) or by an additional processed dielectric film on a passivation layer of the electronic component (108).

8. The package (100) according to any of claims 1 to 7, wherein the integrated circuit substrate (102) is connected with the electronic component (108) with continuous physical contact over an entire main surface of the electronic component (108).

9. The package (100) according to any of claims 1 to 8,
wherein the integrated circuit substrate (102) has a plurality of exposed substrate pads (104);
wherein the electronic component (108) has a plurality of exposed component pads (110);
wherein the integrated circuit substrate (102) is connected with the electronic component (108) so that there is a direct physical contact between each of the substrate pads (104) and each respective one of the component pads (110).

10. The package (100) according to any of claims 1 to 9, wherein the integrated circuit substrate (102) comprises:
a support structure (204) having at least one hole; and
at least two functional inlays (208) placed inside said at least one hole side by side.

11. The package (100) according to any of claims 1 to 9, wherein the integrated circuit substrate (102) comprises:
a central section (304); and
at least two vertically stacked functional volume sections (306) in the central section (304).

12. An integrated circuit substrate (102), which comprises:
a stack (130) comprising at least one electrically conductive layer structure (142) having an exposed substrate pad (104) and at least one electrically insulating layer structure (144) having an exposed substrate dielectric (106); and
a recess (132) at a main surface of the stack (130) in which the exposed substrate pad (104) is retracted with respect to the exposed substrate dielectric (106) by a dimension (d) of less than 1 µm, for example in a range from 1 nm to 20 nm, preferably from 2 nm to 8 nm.

13. The integrated circuit substrate (102) according to claim 12, comprising at least one of the following features:
wherein an exposed surface area (134) of the substrate dielectric (106) on said main surface of said stack (130) has a roughness Ra of less than 10 nm, in particular less than 1 nm;
wherein the exposed substrate dielectric (106) on said main surface of said stack (130) has a coplanarity of less than 500 nm.

14. A method of manufacturing a package (100), wherein the method comprises
providing an integrated circuit substrate (102) having an exposed substrate pad (104) and having an exposed substrate dielectric (106);
providing an electronic component (108) having an integrated circuit (136), having an exposed component pad (110) and having an exposed component dielectric (112); and
connecting the integrated circuit substrate (102) with the electronic component (108) so that there is a direct physical contact between the substrate pad (104) and the component pad (110) and so that there is a direct physical contact between the substrate dielectric (106) and the component dielectric (112).

15. The method according to claim 14, wherein the method comprises:
providing the substrate pad (104) in a recess (132) retracted with respect to the substrate dielectric (106);
providing the component pad (110) in a further recess (128) retracted with respect to the component dielectric (112); and
connecting the integrated circuit substrate (102) with the electronic component (108) so that material of the substrate pad (104) and/or material of the component pad (110) is heated to expand so as to fill the recesses (128, 132).
